**Europäisches Patentamt**

**European Patent Office**

**Office européen des brevets**

(19)

(11) Numéro de publication : **0 659 902 A1**

(12) **DEMANDE DE BREVET EUROPEEN**

(21) Numéro de dépôt : **94402544.4**

(22) Date de dépôt : **10.11.94**

(51) Int. Cl.⁶ : **C23C 16/40,** C23C 16/50, C23C 16/02, H01J 37/32

(30) Priorité : **10.11.93 FR 9313426**

(43) Date de publication de la demande : **28.06.95 Bulletin 95/26**

(84) Etats contractants désignés :
**DE FR GB**

(71) Demandeur : **FRANCE TELECOM Etablissement autonome de droit public, 6, Place d'Alleray F-75015 Paris (FR)**

(72) Inventeur : **Chouan, Yannick 1, Allée des Fougères F-22700 Louannec (FR)**

(74) Mandataire : **Dubois-Chabert, Guy et al Société de Protection des Inventions 25, rue de Ponthieu F-75008 Paris (FR)**

(54) **Procédé de dépôt de couches minces de silice à basse température.**

(57) L'invention concerne le dépôt d'une couche mince de silice sur un substrat par réaction chimique assistée par un plasma généré dans un réacteur à plasma (1), le substrat étant disposé dans une enceinte à vide (5). On réalise la succession d'étapes suivantes : introduction d'oxygène et éventuellement d'argon dans l'enceinte à vide, amorçage du plasma, introduction du silane dans l'enceinte à vide, la pression des gaz dans l'enceinte à vide lors du dépôt étant comprise entre 40 et 80 $\mu$bars, le débit d'argon étant compris entre 0 et 35 cm³/min, le débit de silane étant compris entre 12 et 24 cm³/min, le débit d'oxygène étant compris entre 13 et 35 cm³/min.

FIG.1

EP 0 659 902 A1

La présente invention concerne un procédé de dépôt rapide de couches minces de silice à basse température.

Les technologies de croissance de couches minces de silice sont nombreuses et les domaines d'application variés. Il s'agit généralement de technologies qui mettent en oeuvre des procédés à hautes températures (de 500 à 1000°C).

Une application typique concerne la réalisation d'un guide optique planaire sur un substrat de silicium. Un tel guide optique est décrit dans l'article "Low-loss PECVD Silica Channel Waveguides For Optical Communications" de G. GRAND et al., paru dans Electronics Letters, 6, 1990, vol. 26, n° 25. Le guide est constitué d'une couche tampon ou gaine en silice pure qui assure l'isolement optique du coeur de la structure par rapport au substrat de silicium, d'un coeur en silice dopée qui assure le guidage monomode de la lumière, et d'une couche de recouvrement en silice pure qui assure l'isolement optique. Le procédé de réalisation et les cycles de dépôt sont les suivants. Sur un substrat de silicium monocristallin, on dépose un premier film de silice (environ 10 µm d'épaisseur), puis un film de 5 µm d'épaisseur de silice dopée. Par un procédé de photolithogravure classique, ce film de silice dopée est gravé sous la forme d'un ruban (de section 5 µm x 5 µm) qui constitue le coeur de la structure. Pour constituer la couche de recouvrement, on dépose un film de silice de 5 µm d'épaisseur qui enrobe la structure.

Il est bien connu que la présence de traces d'hydrogène dans la silice augmente son atténuation. C'est pourquoi les procédés de dépôt habituels comportent une étape de recuit à une température de 500°C pour éliminer l'hydrogène occlus ou lié à des atomes de silicium, d'azote ou d'oxygène. Cette étape de recuit à haute température constitue un inconvénient.

Une autre application où il est nécessaire de faire croître des couches de silice est la réalisation d'écrans plats de projection à cristal liquide. Une structure de matrice active d'écran plat à trois niveaux de masquage est décrite dans le document FR-A-2 679 057. Pour des raisons d'industrialisation et par conséquent de prix de revient, on cherche à déposer les couches de silice à basse température. Or les techniques de dépôt de films de silice testées actuellement et compatibles avec un procédé basse température sont le procédé de dépôt chimique en phase vapeur assisté par plasma ou PE-CVD et la pulvérisation cathodique magnétron. Si la qualité des résultats obtenus par ces techniques donne satisfaction (puisque l'atténuation optique n'est pas à considérer ici), les rendements de dépôt sont très faibles. Les temps de dépôt sont trop longs et, semble-t-il, incompatibles avec un projet de développement industriel.

Le procédé selon l'invention permet d'obtenir des dépôts de couches minces de silice ne présentant pas les inconvénients mentionnés ci-dessus. En effet, par ce procédé, on obtient une qualité de silice contenant très peu d'hydrogène à une température proche de 200°C. L'enregistrement d'un spectre d'absorption vibrationnelle infrarouge ne permet pas de déceler de liaison O-H ou Si-H dans le matériau déposé. Les concentrations décelées par analyse SIMS (Secondary Ions Mass Spectroscopy) sont faibles. Elles pourraient être comprises entre 10 et 100 ppm et donc être proches des concentrations obtenues par des techniques à plus hautes températures.

En outre, l'invention permet d'obtenir en quelques minutes des films minces de silice de 0,1 à 10 µm au lieu de quelques dizaines de minutes voire plusieurs heures dans le cas de la pulvérisation cathodique. Ceci permet de résoudre le problème du temps de dépôt trop long et de rendre industrialisables certains projets que l'on ne pourrait autrement développer à faible coût.

Le procédé selon l'invention s'applique pour une machine de dépôt particulière. La machine de dépôt utilisée comprend un réacteur à plasma modifié notamment dans la manière d'injecter les gaz plasmagènes. En effet, le procédé selon l'invention met en oeuvre un mélange de trois gaz composé de silane, d'oxygène et d'argon. Le silane étant un gaz pyrophorique, il s'enflamme spontanément dans l'air pour former un dépôt poudreux de silice. Dans un plasma à basse pression, il est possible de contrôler cette réaction en ajustant la quantité de gaz réactant (l'oxygène) et éventuellement celle d'un gaz de dilution (l'argon). Pour éviter l'oxydation spontanée du silane, on a choisi de séparer l'injection des gaz. Le silane et l'argon sont injectés dans le réacteur à plasma par l'intermédiaire d'une rampe formée d'un tube métallique percé de plusieurs trous orientés vers le substrat. L'oxygène est introduit dans l'enceinte à vide de la machine de dépôt à l'aide d'une simple canne. La réaction conduisant à la formation de silice se fait grâce à la diffusion naturelle des gaz dans le réacteur à plasma. En outre, il est important que le réacteur à plasma de la machine de dépôt soit correctement couplé à la source d'ondes électromagnétiques. Pour cela, on utilise un cornet guide d'onde présentant une évolution progressive de forme. Le procédé peut ainsi être mis en oeuvre de manière efficace grâce à une machine de dépôt la plus simple possible, d'encombrement et de poids réduits et présentant une consommation en énergie la plus faible possible.

L'invention a donc pour objet un procédé de dépôt rapide d'une couche mince de silice sur un substrat, à basse température, au moyen d'une machine de dépôt et par réaction chimique assistée par un plasma des gaz oxygène et silane et sous présence éventuelle d'argon, la machine de dépôt comprenant une source d'ondes électromagnétiques de haute fréquence alimentant un réacteur à plasma communiquant avec une enceinte à vide pourvue d'un porte-substrat, des moyens pour faire le vide dans l'enceinte à vide, des moyens de chauffage du porte-substrat et des moyens d'alimentation en gaz oxygène et silane constitués d'organes séparés, caractérisé en ce que, la machine de dépôt n'utilisant pas l'effet de résonance cyclotronique électronique mais comprenant un cornet guide d'onde permettant, par une évolution progressive de forme, un couplage correct de la source d'ondes électromagnétiques au réacteur à plasma, il comporte la succession d'étapes suivantes : introduction d'oxygène et éventuellement d'argon dans l'enceinte à vide, amorçage du plasma, introduction du silane dans l'enceinte à vide, la pression des gaz dans l'enceinte à vide lors du dépôt étant comprise entre 40 et 80 μbars, le débit d'argon étant compris entre 0 et 35 cm³/min, le débit de silane étant compris entre 12 et 24 cm³/min, le débit d'oxygène étant compris entre 13 et 38 cm³/min, la température du substrat étant comprise entre 200 et 300°C, la puissance mise en jeu dans le réacteur à plasma étant comprise entre 750 et 1100 W.

Selon un mode de fonctionnement préféré la pression des gaz dans l'enceinte à vide lors du dépôt est d'environ 60 μbars, le débit d'argon est d'environ 10 cm³/min, le débit de silane est d'environ 12 cm³/min, le débit d'oxygène est compris entre 26 et 38 cm³/min, la température du substrat est d'environ 200°C et la puissance mise en jeu est d'environ 1100 W.

De la phosphine peut également être introduite dans l'enceinte à vide pour doper ladite couche mince de silice.

Avantageusement, les organes d'alimentation en silane et en oxygène aboutissent l'un dans le réacteur à plasma et l'autre dans l'enceinte à vide.

L'organe d'alimentation en oxygène peut être une canne d'injection aboutissant dans l'enceinte à vide, l'organe d'alimentation en silane étant une rampe d'injection aboutissant dans le réacteur à plasma.

Le substrat peut être préchauffé à la température désirée avant l'opération de dépôt et ne plus être chauffé pendant l'opération de dépôt. On pense que ceci contribue à obtenir une bonne qualité du dépôt de silice, le plasma entretenant l'équilibre thermique pendant le dépôt. Ce mode de chauffage du substrat s'applique notamment au cas où l'on effectue des dépôts en série, les substrats défilant devant le réacteur à plasma. Les substrats sont alors préchauffés à la température désirée avant leur passage devant le réacteur.

L'invention sera mieux comprise et d'autres avantages et particularités apparaîtront à la lecture de la description qui va suivre, donnée à titre d'exemple non limitatif, accompagnée des dessins annexés parmi lesquels :

- la figure 1 représente une machine de dépôt de couches minces de silice pour la mise en oeuvre de l'invention,
- la figure 2 est un diagramme donnant la transmittance de films de silice déposés selon le procédé de l'invention,
- la figure 3 est un diagramme donnant la transmittance optique d'un film de silice déposé selon le procédé de l'invention,
- la figure 4 est un diagramme comparatif donnant la transmittance optique de deux films de silice déposés selon le procédé de l'invention, l'un étant traité thermiquement et l'autre non,
- la figure 5 représente une structure de test MIS,
- la figure 6 est un diagramme montrant l'évolution de la constante diélectrique relative d'un film de silice selon l'invention en fonction des débits relatifs de silane et d'oxygène,
- la figure 7 est un diagramme donnant la caractéristique C(V) obtenue pour un film de silice déposé selon l'invention,
- la figure 8 est un diagramme donnant la caractéristique I(V) obtenue pour un film de silice déposé selon l'invention.

La procédure en trois étapes mise au point pour l'introduction des gaz dans l'enceinte à vide de la machine de dépôt et pour l'amorçage du plasma, permet d'éviter une réaction spontanée non contrôlée entre silane et oxygène . Dans une première étape, on introduit l'oxygène et éventuellement l'argon. Dans une seconde étape, le plasma est amorcé. Dans une troisième étape, on introduit le silane.

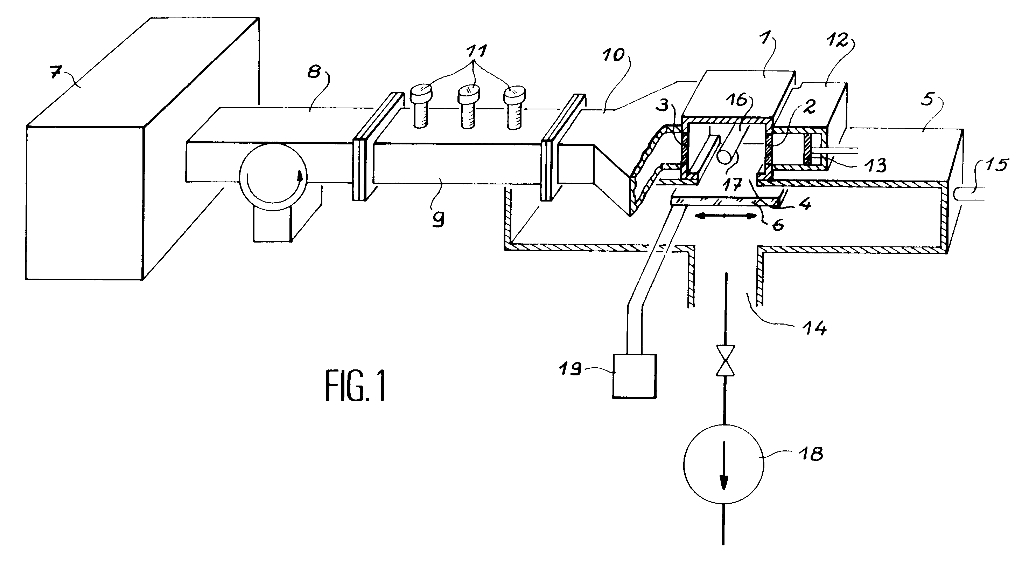

La machine de dépôt représenté à la figure 1 comprend un réacteur à plasma 1 constitué par une enceinte en forme de parallélépipède rectangle à faces généralement métalliques, par exemple en aluminium. Deux faces opposées du réacteur comprennent des parois 2 et 3 réalisées en matériau à faibles pertes diélectriques, par exemple en silice. La face inférieure de l'enceinte, perpendiculaire aux parois 2 et 3, comporte une ouverture 4 qui assure la communication de l'enceinte à plasma avec une enceinte à vide 5 dans laquelle est logée le porte-substrat mobile et chauffant 6. Ce porte-substrat peut être chauffé à l'aide d'une résistance électrique alimentée en courant par une source de tension 19 ou encore au moyen de rayons infrarouges.

La machine de dépôt comporte aussi un générateur micro-onde 7 capable de générer une onde électromagnétique de puissance suffisante pour générer un plasma dans le réacteur 1. Le générateur micro-onde 7 est relié au réacteur 1 par un circulateur 8 protégeant le générateur 7 des éventuelles réfexions des ondes hyperfréquences créées à l'intérieur du réacteur, un guide d'ondes 9 et un cornet de couplage 10 aboutissant sur la paroi 3. Le guide d'ondes 9 est muni de vis d'accord 11 pénétrant à l'intérieur du guide, par exemple au nombre de trois, permettant d'adapter l'impédance du réacteur pour obtenir un bon rendement dans la transmission des ondes vers le réacteur à plasma 1.

Le cornet 10 permet, par une évolution progressive de forme, de coupler correctement le guide d'ondes 9 au réacteur à plasma 1.

Un autre guide d'ondes, référencé 12, est disposé contre le réacteur 1, en vis-à-vis de la paroi 2. Ce guide d'ondes 12 comporte un piston 13 capable d'être déplacé selon la direction de propagation de l'onde électromagnétique générée par le générateur 7. L'ajustement des vis pénétrantes 11 ainsi que la position du piston 13 permet d'établir un couplage du réacteur 1 non rayonnant, éliminant ainsi tout rayonnement électromagnétique du réacteur 1 vers l'extérieur.

L'enceinte à vide 5 comporte un orifice de pompage 14 permettant de faire le vide dans l'enceinte 5 au moyen d'une pompe à vide 18.

L'injection de l'oxygène est effectuée par une canne d'injection 15 qui aboutit dans l'enceinte à vide 5. Le silane et l'argon sont introduits conjointement par une rampe d'injection 16 en forme de tube comportant des trous 17 disposés selon l'une des génératrices du tube 16, les trous 17 étant dirigés vers l'ouverture 4 du réacteur à plasma.

La fréquence de fonctionnement du générateur 7 est avantageusement de 2,45 GHz pour une puissance délivrée comprise entre 750 et 1100 W.

La machine de dépôt représentée à la figure 1 n'utilise pas l'effet de résonance cyclotronique électronique (RCE) généralement utilisé dans les plasmas de dépôt micro-ondes.

Les essais ont montré qu'avec la machine de dépôt décrite à la figure 1, on obtient des résultats satisfaisants en travaillant dans les conditions suivantes :

- pression des gaz dans l'enceinte à vide comprise entre 40 et 80 µbars,
- débit d'argon compris entre 0 et 35 cm³/min,
- débit de silane $SiH_4$ compris entre 12 et 24 cm³/min,
- débit d'oxygène compris entre 13 et 38 cm³/min,
- puissance mise en jeu comprise entre 750 et 1100 W,
- température du substrat comprise entre 200 et 300°C.

Les dépôts de silice obtenus ont fait l'objet de caractérisations optique et électrique. La caractérisation optique a été menée par spectrophotométrie, spectroscopie infrarouge (FTIR) et ellipsométrie sur des films de 150 nm d'épaisseur.

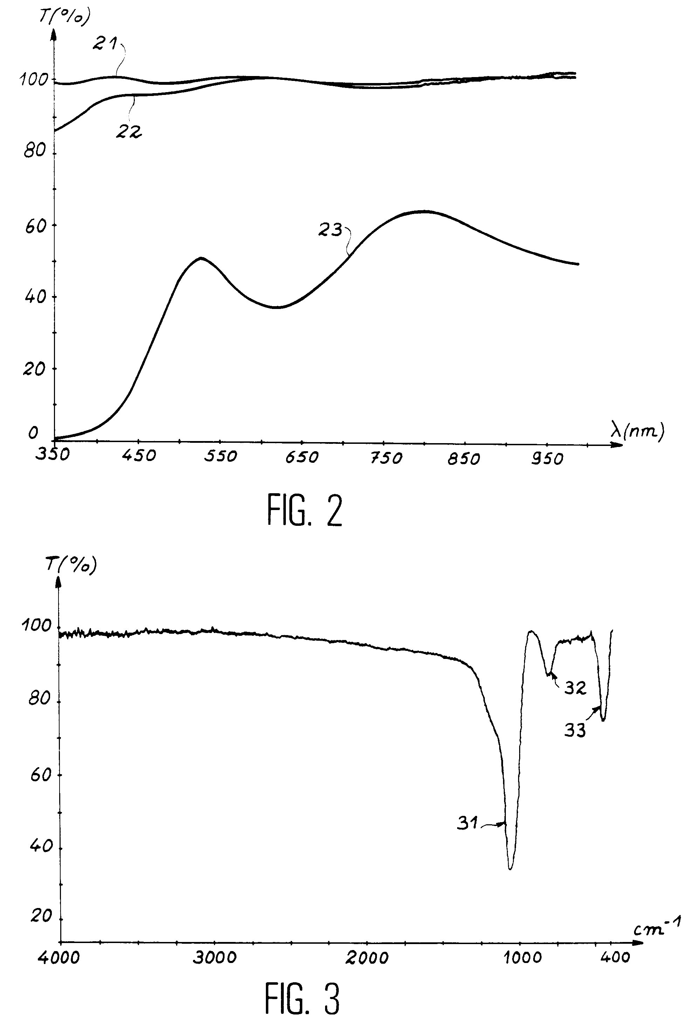

Les courbes 21, 22 et 23 présentées dans le diagramme de la figure 2 ont été obtenues par spectrophotométrie. Elles représentent la transmittance T de trois couches de silice en fonction de la longueur d'onde λ de la lumière dans le domaine du visible.

La courbe 21 est relative à un film de silice obtenu dans des conditions optimales de débits $SiH_4/O_2$ = 0,3, soit des débits de 12 cm³/min de $SiH_4$, 38 cm³/min d'$O_2$ et 10 cm³/min d'Ar. Ce film de silice a une transmittance proche de 100% dans tout le spectre du visible.

La courbe 22 est relative à un film de silice obtenu pour un rapport de débits $SiH_4/O_2$ = 0,9, soit des débits de 24 cm³/min de $SiH_4$, 26 cm³/min d'$O_2$ et 10 cm³/min d'Ar. Ce film est légèrement absorbant.

La courbe 23 est relative à un film de silice obtenu pour un rapport de débits $SiH_4/O_2$ = 0,3 mais sans argon, soit 12 cm³/min de $SiH_4$ et 38 cm³/min d'$O_2$. Actuellement, on ne peut émettre aucune hypothèse sur le rôle de l'argon dans la cinétique de dissociation du silane et/ou de la cinétique de croissance du film de silice. On ne peut que constater le rôle actif de l'argon dans la croissance des couches. Des mesures par spectrométrie de masse ont révélé un taux de dissociation du silane quasi complet.

Cette mesure de transmittance permet de montrer la nécessité d'adjoindre aux gaz de dépôt un débit d'argon pour obtenir une bonne transmittance de la couche de silice. En pratique, le débit d'argon sera égal à 10 cm³/min.

La silice thermique stoechiométrique possède trois bandes d'absorption caractéristiques situées à 1080, 800 et 460 cm⁻¹. Ces modes de vibration sont appelés respectivement "stretching", "bending" et "rocking". Pour plus de précisions, on peut se reporter à l'article "Submicron Thickness Calibration of Vapor Deposition $SiO_2$ Films by Infrared Spectroscopy" de J. WONG paru dans Journal of Applied Physics 44(12) Décembre 1973, page 5629.

Le diagramme de la figure 3 représente une courbe de transmittance T pour un film de silice déposé selon le procédé de l'invention, cette courbe ayant été relevée par spectroscopie infrarouge dans l'intervalle allant de 400 à 4000 cm⁻¹. La courbe représente un spectre typique de silice thermique stoechiométrique. On reconnaît les trois bandes d'absorption caractéristiques 31, 32 et 33.

La présence de groupements OH se manifeste par une forte absorption vers 3660 cm⁻¹. La courbe de la figure 3 ne montre aucune trace d'absorption à ce nombre d'onde. Compte tenu de la sensibilité de l'appareil estimé à 10⁻² DO, on peut considérer en première approximation que la teneur en liaisons O-H est inférieure à 1% atomique.

Pour des pressions de gaz dans l'enceinte de dépôt variant de 40 à 80 ubars, on note que les valeurs de FWHM (largeur à mi-hauteur) de la bande à 1080 cm⁻¹ diminuent. On note également une diminution de l'intensité de l'épaulement au pied de cette raie. D'après l'article "Infrared Study of $SiO_x$ Films Produced by Plasma Enhanced Chemical Vapor Deposition" de PAI et al., paru dans Journal of Vacuum Science Technologies A4(3), Mai-Juin 1986, page 689, l'intensité de cet épaulement est à relier au degré de désordre structurel du matériau.

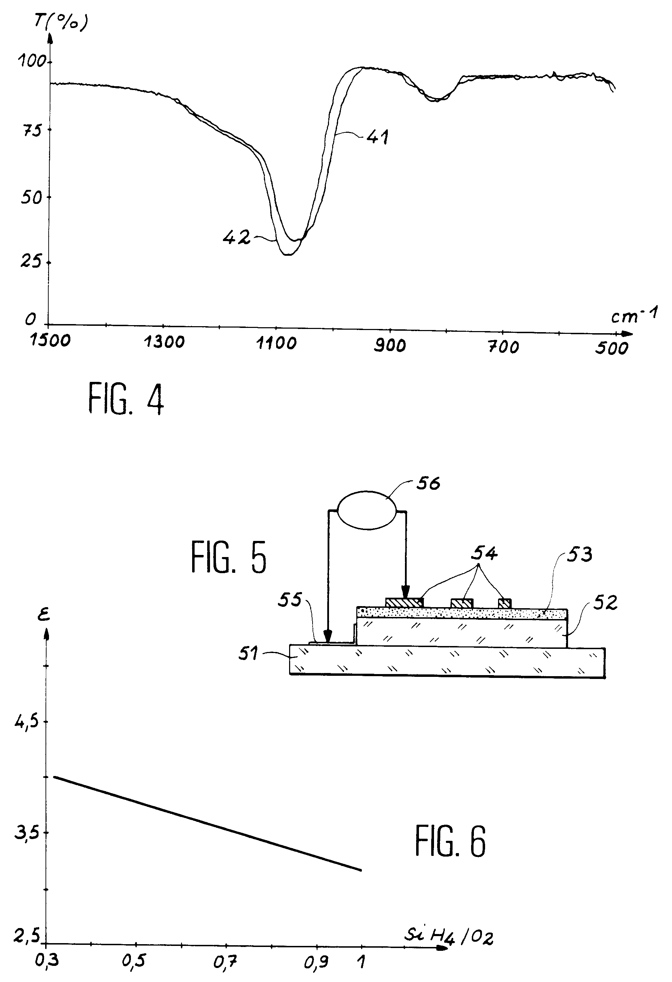

Si les films déposés à 200°C subissent une densification obtenue par un recuit à 600°C pendant 1 heure, on observe un décalage d'environ 10 cm$^{-1}$ du pic de "stretching" vers 1080 cm$^{-1}$. Ceci peut se constater sur le diagramme de la figure 4 où la courbe 41 se rapporte à un échantillon non densifié et la courbe 42 à un échantillon densifié. On observe également une diminution de la valeur de FWHM et de l'épaulement.

En conclusion, il n'est pas possible de déceler, par spectroscopie infrarouge (FTIR), de liaisons O-H dans une silice déposée selon l'invention à une température de 200°C. On peut donc estimer, compte tenu de la sensibilité de la mesure, que la concentration d'hydrogène contenu dans le matériau est inférieure à 1% atomique. Des pressions élevées (supérieures à 60 µbars) permettent d'obtenir un matériau proche de la stoechiométrie. Un recuit à 600°C permet d'obtenir l'enregistrement d'un spectre FTIR équivalent à celui obtenu pour une silice thermique.

L'estimation de la concentration d'hydrogène a été affinée par une mesure au SIMS (Secondary Ions Mass Spectroscopy). Par des mesures comparatives avec des silices déposées à plus haute température, la concentration d'hydrogène est estimée entre 10 et 100 ppm.

Les valeurs mesurées de l'indice de réfraction n à 0,6 et 1,2 µm sont légèrement supérieures à celle de la silice thermique (pour laquelle n est compris entre 1,465 et 1,467). Ces valeurs élevées peuvent être attribuées à la porosité du film ou à un excès de silicium dans le matériau (on aurait SiO$_x$ avec x < 2). L'incertitude sur la mesure ne permet pas de définir des sens d'évolution précis en fonction des conditions de dépôt. Toutefois, pour des conditions de dépôt supposées optimisées à une température de 200°C ou proche de celle-ci, on relève une valeur de n comprise entre 1,467 et 1,480.

Pour effectuer la caractérisation électrique des couches de silice déposées selon la présente invention, on réalise des structures de test MIS du type représenté à la figure 5. Ces structures sont bien connues de l'homme de l'art. Le banc de mesure permettant d'effectuer ce test comprend un premier substrat 51 en silicium fortement dopé n et supportant un second substrat 52 en silicium monocristallin intrinsèque sur lequel a été déposé la couche de silice 53 à contrôler. Une grille, constituée de plots circulaires 54 en alliage d'aluminium et de titane, est déposée sur la face libre de la couche 53. Chaque plot représente l'électrode d'une capacité. Un traceur C-V (par exemple le modèle 410 de Princeton Applied Research) 56 est connecté entre la grille et une électrode 55 en pâte d'argent déposée à la jonction des substrats 51 et 52. Le banc de mesure comprend encore une table traçante pour le relevé des mesures, un picoampèremètre (par exemple un modèle Keithley) pour le tracé des courbes de courant I traversant la structure en fonction du potentiel V appliqué, c'est-à-dire les courbes C(V) quasi-statiques.

Deux types de courbes peuvent ainsi être tracés. Les courbes C(V) haute fréquence sont élaborées à partir d'un signal sinusoïdal de 1 MHZ superposé à la rampe de tension sur la grille. On mesure ainsi la capacité différentielle dQ/dV due aux mouvements des porteurs majoritaires qui seuls peuvent suivre les variations haute fréquence. Les courbes quasi-statiques I(V) sont élaborées grâce à une seule rampe de tension appliquée à la grille. Ceci est l'équivalent d'un signal appliqué de fréquence extrêmement faible. Des courbes C(V) peuvent être tracées en mesurant les variations de la capacité présente entre l'électrode 55 et la grille en fonction du potentiel appliqué à ces terminaisons. Pour de fortes valeurs positives du potentiel, la capacité totale s'écrit :

$$C = \varepsilon\varepsilon_o \frac{S}{d}$$

avec :

$\varepsilon$ = constante diélectrique relative de la silice déposée,

$\varepsilon_o$ = permittivité de l'air,

S = surface des électrodes de la capacité,

d = épaisseur de la silice.

La valeur de $\varepsilon$ est relativement sensible à tous les paramètres de dépôt de la silice et particulièrement au rapport des débits SiH$_4$/O$_2$. La figure 6 montre la variation de la constante diélectrique $\varepsilon$ en fonction des détails relatifs de silane et d'oxygène pour un débit d'argon de 10 cm³/min. D'après la courbe représentée, on voit qu'une valeur de $\varepsilon$ proche de 4 est obtenue pour un rapport de débits SiH$_4$/O$_2$ égal à 0,3.

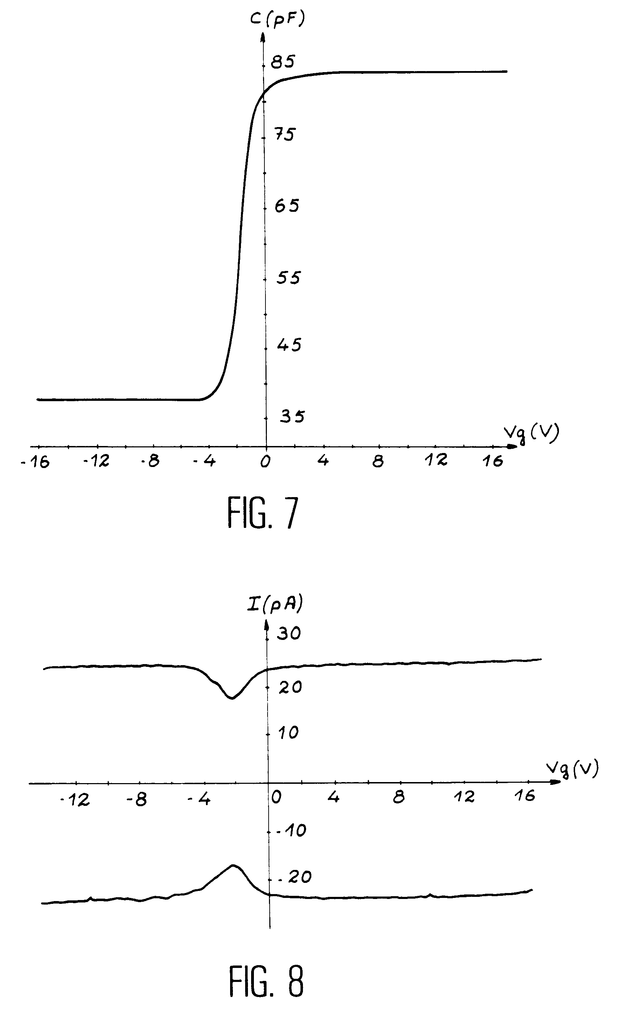

Le diagramme de la figure 7 donne la caractéristique C(V) typique obtenue pour un film de silice déposé à une température de 200°C. L'épaisseur du film est de 320 nm et sa constante diélectrique relative est de 3,9. On note un très faible hystérésis représentatif d'une faible concentration de charges dans le matériau.

La figure 8 représente la caractéristique I(V) pour le même échantillon. Cette courbe a été tracée pour une vitesse de rampe de 290 mV/s.

Ces résultats électriques montrent que la qualité de la silice déposée doit permettre la réalisation d'un masque optique isolé par un film déposé par plasma micro-onde.

Pour obtenir un film de silice possédant les propriétés optiques et électriques les meilleures, on utilisera plus particulièrement les conditions suivantes : pression des gaz dans le réacteur environ 60 µbars, débit d'argon 10 cm³/min, débit de SiH$_4$ 12 cm³/min, débit d'O$_2$ de 26 à 38 cm³/min, puissance 1100 W, température du substrat 200°C.

La vitesse de croissance des films de silice est alors de 1 à 1,5 nm/s. Cette vitesse de croissance n'est pas limitée par le principe mis en oeuvre. Un groupe à vide plus puissant et des débitmètres de plus grand débit permettraient d'obtenir des vitesses de croissance beaucoup plus élevées. En effet, des mesures de spectroscopie quadripolaire ont montré que l'efficacité de dissociation du plasma est très grande. La forte densité électronique du plasma, estimée à $10^{11}$ - $10^{13}$, conduit à une dissociation totale du $SiH_4$ suivant un mécanisme du type :

$$SiH_4 + e \rightarrow Si + 4H + e$$

Une des conséquences de ce fort taux de dissociation est de faire chuter brutalement la pression lors de l'amorçage du plasma. Dans le cas particulier du dépôt de silice, la pression chute de 20% environ au cours de l'opération de dépôt.

L'invention permet la réalisation de films de silice dopés en introduisant de la phosphine ($PH_3$) aux gaz mis en oeuvre.

La phosphine peut être introduite par la rampe d'injection 16, comme le silane et l'argon.

Il est également possible de réaliser un nettoyage du réacteur à l'aide d'un plasma de gravure de type $Ar/SF_6$. La vitesse de gravure obtenue est équivalente à la vitesse de dépôt.

La présente invention semble particulièrement intéressante pour les applications optoélectroniques. En effet, la réalisation de films minces de silice à basse température et sur de grandes surfaces, par exemple 33 x 35,5 cm (soit 13 x 14 pouces), devrait permettre un gain appréciable sur la qualité de la connectique associée et sur le coût de fabrication.

La silice déposée par le procédé selon l'invention est de qualité "micro-électronique" puisqu'on peut réaliser des isolants de grille de transistor. Elle est aussi de qualité "optique" et peut par exemple permettre la réalisation de coupleurs de type COIP. Elle est également très faiblement contrainte : des dépôts de l'ordre de 15 à 25 µm d'épaisseur ont été réalisés sans décollement.

## Revendications

1. Procédé de dépôt rapide d'une couche mince de silice sur un substrat, à basse température, au moyen d'une machine de dépôt et par réaction chimique assistée par un plasma des gaz oxygène et silane et sous présence éventuelle d'argon, la machine de dépôt comprenant une source d'ondes électromagnétiques de haute fréquence (7) alimentant un réacteur à plasma (1) communiquant avec une enceinte à vide (5) pourvue d'un porte-substrat (6), des moyens (8) pour faire le vide dans l'enceinte à vide, des moyens de chauffage (19) du porte-substrat (6) et des moyens d'alimentation en gaz oxygène et silane constitués d'organes séparés, caractérisé en ce que, la machine de dépôt n'utilisant pas l'effet de résonance cyclotronique électronique mais comprenant un cornet guide d'onde (10) permettant, par une évolution progressive de forme, un couplage correct de la source d'ondes électromagnétiques (7) au réacteur à plasma (1), il comporte la succession d'étapes suivantes : introduction d'oxygène et éventuellement d'argon dans l'enceinte à vide, amorçage du plasma, introduction du silane dans l'enceinte à vide, la pression des gaz dans l'enceinte à vide lors du dépôt étant comprise entre 40 et 80 µbars, le débit d'argon étant compris entre 0 et 35 $cm^3$/min, le débit de silane étant compris entre 12 et 24 $cm^3$/min, le débit d'oxygène étant compris entre 13 et 38 $cm^3$/min, la température du substrat étant comprise entre 200 et 300°C, la puissance mise en jeu dans le réacteur à plasma étant comprise entre 750 et 1100 W.

2. Procédé de dépôt selon la revendication 1, caractérisé en ce que la pression des gaz dans l'enceinte à vide lors du dépôt est d'environ 60 µbars, le débit d'argon est d'environ 10 $cm^3$/min, le débit de silane est d'environ 12 $cm^3$/min, le débit d'oxygène est compris entre 26 et 38 $cm^3$/min, la température du substrat en d'environ 200°C et la puissance mise en jeu est d'environ 1100 W.

3. Procédé selon l'une des revendications 1 à 2, caractérisé en ce que, en vue de doper ladite couche mince de silice, on introduit également de la phosphine dans l'enceinte à vide.

4. Procédé de dépôt selon l'une quelconque des revendications 1 à 3, caractérisé en ce que les organes d'alimentation en silane et en oxygène aboutissent l'un dans le réacteur à plasma (1) et l'autre dans l'enceinte à vide (5).

5. Procédé de dépôt selon la revendication 4, caractérisé en ce que l'organe d'alimentation en oxygène est une canne d'injection (15) aboutissant dans l'enceinte à vide, l'organe d'alimentation en silane étant une rampe d'injection (16) aboutissant dans le réacteur à plasma (1).

6. Procédé de dépôt selon la revendication 5, caractérisé en ce que la rampe d'injection (16) est un tube comportant des trous (17) disposés selon l'une des génératrices du tube, les trous étant dirigés vers l'enceinte à vide (5).

7. Procédé de dépôt selon l'une quelconque des revendications 1 à 6, caractérisé en ce que l'organe d'alimentation en silane (16) permet également l'alimentation en argon.

8. Procédé de dépôt selon l'une quelconque des revendications 1 à 7, caractérisé en ce que le substrat est préchauffé à ladite température avant l'opération de dépôt et n'est plus chauffé pendant l'opération de dépôt.

9. Procédé de dépôt selon la revendication 8, caractérisé en ce que le substrat défile devant le réacteur à plasma (1).

10. Procédé de dépôt selon la revendication 9, caractérisé en ce que le chauffage du substrat est réalisé au moyen de rayons infrarouges.

FIG.1

EP 0 659 902 A1

FIG. 2

FIG. 3

FIG. 4

FIG. 5

FIG. 6

FIG. 7

FIG. 8

**Office européen des brevets**

## RAPPORT DE RECHERCHE EUROPEENNE

Numero de la demande

EP 94 40 2544

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | DE-A-42 29 161 (FUJI ELECTRIC CO) <br> * page 11, ligne 47 - ligne 50; exemple 2 * <br> --- | 1-10 | C23C16/40 <br> C23C16/50 <br> C23C16/02 <br> H01J37/32 |
| A | IBM TECHNICAL DISCLOSURE BULLETIN, <br> vol. 31,no. 10, Mars 1989 NEW YORK, US, <br> pages 314-317, <br> ANONYMOUS 'High Rate Plasma Deposition System' <br> * figures 1,2 * <br> --- | 1-10 | |
| A | PATENT ABSTRACTS OF JAPAN <br> vol. 011 no. 371 (C-462) ,3 Décembre 1987 <br> & JP-A-62 142783 (CANON INC) 26 Juin 1987, <br> * abrégé * <br> --- | 1-10 | |
| A | EP-A-0 012 440 (INTERNATIONAL BUSINESS MACHINES CORPORATION) <br> * page 6, ligne 18 - page 7, ligne 12 * <br> --- | 1-10 | |
| A | JOURNAL OF VACUUM SCIENCE AND TECHNOLOGY, B, <br> vol. 6, U.S.A, <br> page 470 <br> K.J. SCOLES ET AL. 'DEPOSITION AND CHARACTERIZATION OF SILICON DIOXIDE THIN FILMS DEPOSITED BY MERCURY-ARC-SOURCE DRIVEN PHOTO-ACTIVATED CHEMICAL-VAPOR DEPOSITION' <br> *EXPERIMENT* <br> --- | 1-10 | **DOMAINES TECHNIQUES RECHERCHES (Int.Cl.6)** <br><br> C23C |

-/--

Le présent rapport a été établi pour toutes les revendications

| Lieu de la recherche | Date d'achèvement de la recherche | Examinateur |
|---|---|---|
| LA HAYE | 6 Avril 1995 | Ekhult, H |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

........................................................................

& : membre de la même famille, document correspondant

EPO FORM 1503 03.82 (P04C02)

**Office européen des brevets**

# RAPPORT DE RECHERCHE EUROPEENNE

Numero de la demande

EP 94 40 2544

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | APPLIED PHYSICS LETTERS, vol. 60, U.S.A, page 434 T. YASUDA ET AL. 'LOW TEMPERATURE PREPARATION OF SIO2/SI(100) INTERFACES USING A TWO-STEP REMOTE PLASMA-ASSISTED OXIDATION DEPOSITION PROCESS' * page 434, colonne de gauche, ligne 16 - colonne de droite, ligne 10 *<br>--- | 1-10 | |
| A | FR-A-2 636 078 (SCHOTT GLASWERKE) 9 Mars 1990 * page 5, ligne 17 - ligne 30 *<br>----- | 1-10 | |
| | | | **DOMAINES TECHNIQUES RECHERCHES (Int.Cl.6)** |

Le présent rapport a été établi pour toutes les revendications

| Lieu de la recherche | Date d'achèvement de la recherche | Examinateur |
|---|---|---|
| LA HAYE | 6 Avril 1995 | Ekhult, H |